# EUROPEAN PATENT SPECIFICATION

(11) **EP 1 531 466 B1**
(45) Date of publication and mention of the grant of the patent: **07.01.2009**
(21) Application number: 04257076.2
(22) Date of filing: 16.11.2004
(51) Int. Cl.: G11B 7/125, H01S 5/183, H01S 5/187, H01S 5/42, G11B 7/0065

(54) **Wavelength-tunable light source**
Lichtquelle mit abstimmbaren Wellenlängen
Source de lumière accordable en longueur d'onde

(30) Priority: 17.11.2003 JP 2003387054
(43) Date of publication of application: 18.05.2005
(73) Proprietor: ALPS ELECTRIC CO., LTD., Ota-ku Tokyo 145 (JP)
(72) Inventor: Mitsuya, Shinji, c/o Alps Electric Co., Ltd., Tokyo (JP)
(74) Representative: Kensett, John Hinton

(56) References cited:
- EP-A2- 1 182 758
- US-A1- 2002 086 454
- US-B1- 6 445 470
- WIPIEJEWSKI T ET AL: "Multiple wavelength vertical-cavity laser array employing molecular beam epitaxy regrowth" ELECTRONICS LETTERS IEE UK, vol. 32, no. 4, 15 February 1996 (1996-02-15), pages 340-342, XP002445045 ISSN: 0013-5194
- NODA S ET AL: "2D PHOTONIC CRYSTAL SURFACE-EMITTING LASER USING TRIANGULAR-LATTICE STRUCTURE" IEICE TRANSACTIONS ON ELECTRONICS, ELECTRONICS SOCIETY, TOKYO, JP, vol. E85-C, no. 1, January 2002 (2002-01), pages 45-51, XP001116762 ISSN: 0916-8524

## Description

### BACKGROUND OF THE INVENTION

### 1. Field of the Invention

The present invention relates to a wavelength-tunable light source for a holographic memory device and a method for fabricating the wavelength-tunable light source, and more particularly, to a wavelength-tunable light source employing a surface-emitting laser and a method for fabricating the wavelength-tunable light source.

### 2. Description of the Related Art

Memory devices that magnetically or optically record or reproduce information onto or from media in two dimensions have been widely used for computers or the like. Examples of such magnetic memory devices include a hard disk, and examples of such optical memory devices include a CD or DVD. To respond to market demand for higher memory capacity, these memory devices have achieved high storage density. Now, for even higher memory capacity, novel memory devices utilizing holography are being developed.

Holographic memory devices write information onto a medium per page as a hologram and reconstruct the hologram. Page-based encoded information is written on the medium as a pattern such as a change in refractive index. This pattern is a hologram formed through the interference between a signal beam and a reference beam in the memory device. To reproduce the information written on the medium, the medium is illuminated with the reference beam, and the incident light is diffracted by the hologram. The diffracted light is received by an optoelectronic transducer such as a CCD or CMOS device.

One of the distinctive features of the holographic memory device is that the holographic memory device can record information on a medium via spatial multiplexing and thus can provide very high storage density. Angle multiplexing and wavelength multiplexing are well-known examples of spatial multiplexing. In angle multiplexing, information is recorded by shifting the incident angle of a reference beam, whereas in wavelength multiplexing, information is recorded by shifting the wavelength of a reference beam. To reproduce information recorded on a medium through wavelength multiplexing, a wavelength-tunable light source capable of oscillating light beams with different wavelengths is necessary to emit the reference beams.

Examples of known wavelength-tunable light sources include an external-resonator-type laser and a distributed bragg reflector (DBR) type wavelength-tunable laser. With the former laser, an external resonator is composed of a semiconductor laser and an external reflector. By varying the angle of the external reflector, the length of the external resonator is changed, thereby altering the wavelength of the laser. This type of laser is disclosed in Japanese Unexamined Patent Application Publication No. 2003-69146, for example. With the latter laser, a current is injected into a DBR region in the DBR-type wavelength-tunable laser with three electrodes, and the wavelength of the laser is tuned by using a shift in refractive index (bragg wavelength) due to a plasma effect. This type of laser is disclosed in Japanese Unexamined Patent Application Publication No. 8-236869, for example.

When the known wavelength-tunable light sources are used in the holographic memory devices, they suffer from the following problems. Since it is necessary to precisely control the movement of the external reflector in the external-resonator-type laser, as described above, the external-resonator-type laser tends to be expensive. Furthermore, if the external-resonator-type laser is vibrated due to a shock, for example, the wavelength of the laser becomes unstable. Moreover, it takes some time to switch wavelengths in the external-resonator-type laser, resulting in a limited switching speed. Specifically, when the holographic memory device is used for read only memory (ROM), the memory device is used in various environments where a shock might be applied to the memory device. Thus, the external-resonator-type laser is not suitable for use in ROMs due to its sensitivity to vibration.

Furthermore, according to the DBR-type wavelength-tunable laser, the tunable range of wavelength is not wide enough for the wavelength multiplexing employed in the holographic memory. In this regard, the DBR-type wavelength-tunable laser is not suitable for holographic memory devices. As has been described, the known wavelength-tunable light sources are not desired for holographic memory devices in consideration of various applications of the holographic memory device.

NODA S ET AL: "2D PHOTONIC CRYSTAL SURFACE-EMITTING LASER USING TRIANGULAR-LATTICE STRUCTURE" IEICE TRANSACTIONS ON ELECTRONICS, ELECTRONICS SOCIETY, TOKYO, JP, vol. E85-C, no. 1, January 2002, pages 45-51, discloses a two-dimensional photonic crystal surface-emitting laser, emitting at a stable single-mode wavelength, with a triangular lattice structure embedded in the lower clad layer by wafer fusion technique.

EP-A-1 182 758, US 2002/086454 A, and WIPIEJEWSKI T ET AL: "Multiple wavelength vertical-cavity laser array employing molecular beam epitaxy regrowth" ELECTRONICS LETTERS IEE UK, vol. 32, no. 4, 15 February 1996, pages 340-342, all disclose multiple wavelength DBR VCSEL arrays, with a plurality of DBR surface emitting laser elements being formed on a single substrate, each element capable of emitting at a different singlemode wavelength.

### SUMMARY OF THE INVENTION

It is an object of the present invention to provide a wavelength-tunable light source suitable for the use in a holographic memory device. Moreover, this wavelength-tunable light source has high vibration resistance and switches wavelength at high speed.

A wavelength-tunable light source of the present invention is defined in claim 1 and includes a substrate and an emitting section disposed on the substrate and emitting light beams having a plurality of single wavelengths, the emitting section including a plurality of surface-emitting elements disposed on the substrate in close proximity to each other, the number of surface-emitting elements corresponding to the number of single wavelengths of the light beams emitted from the emitting section.

According to the wavelength-tunable light source of the present invention, preferably the light beams having the single wavelengths are incident on substantially the same position of an illuminated object, the light beams being emitted from the respective surface-emitting elements in the emitting section.

According to the wavelength-tunable light source of the present invention, preferably the illuminated object is a medium in which holograms are recorded by wavelength multiplexing, and the surface-emitting elements emit respective reference beams having wavelengths necessary for reconstruction of the holograms.

According to the wavelength-tunable light source of the present invention, each of the surface-emitting elements includes two cladding layers and an active layer, the active layer generating light and being disposed between the cladding layers, one of the cladding layers including a region having a two-dimensional periodic refractive index structure.

According to the wavelength-tunable light source of the present invention, each of the surface-emitting elements in the emitting section has a different periodic refractive index structure, and the respective cladding layers of the surface-emitting elements have the same thickness as each other.

According to the wavelength-tunable light source of the present invention, preferably the surface-emitting elements are disposed on the circumference of a circle in close proximity to each other on the substrate.

According to the wavelength-tunable light source of the present invention, preferably the surface-emitting elements are disposed in a line in close proximity to each other on the substrate.

In a method for forming a wavelength-tunable light source according to the present invention as defined in claim 6, the wavelength-tunable light source includes an emitting section on a substrate, the emitting section emitting light beams with a plurality of single wavelengths. The method for forming a wavelength-tunable light source of the present invention includes the steps of forming sub-lower-cladding layers in close proximity to each other on the substrate, the number of sub-lower-cladding layers corresponding to the number of wavelengths of the light beams to be emitted from the emitting section; forming photoresists having different two-dimensional periodic patterns on top of the sub-lower-cladding layers by lithography; etching the sub-lower-cladding layers through the photoresists to form different two-dimensional periodic structures on the respective sub-lower-cladding layers, thereby forming bottom structures; forming upper structures including main-lower cladding layers, upper cladding layers, and active layers, the active layers generating light and being disposed between the main-lower cladding layers and the upper cladding layers; and connecting the upper face of the bottom structures with the bottom face of the upper structures by fusion, thereby forming surface-emitting elements in the emitting section.

According to the wavelength-tunable light source of the present invention, since light having different wavelengths is emitted from the respective surface-emitting elements without an actuator, the wavelength-tunable light source of the present invention has vibration resistance and can switch the wavelengths of light beams emitted from the surface-emitting elements at high speed. Since the wavelengths of the surface-emitting elements can be freely selected, the tunable wavelength band of the light emitted from each surface-emitting element is wide. Furthermore, since the surface-emitting elements are disposed in close proximity on the substrate and thus are free from positional dependency, they can function as a single wavelength-tunable light source. Accordingly, the wavelength-tunable light source of the present invention is suitable for use in the holographic memory device.

According to the wavelength-tunable light source of the present invention, since the surface-emitting elements are surface-emitting lasers in which the active layers are disposed between the cladding layers, all the surface-emitting elements are formed simultaneously on the substrate, thereby facilitating the fabrication process. Furthermore, since one of the cladding layers has the two-dimensional periodic refractive index structure, the surface-emitting elements are formed so as to emit light beams with different wavelengths by changing the periods of the periodic structures through lithography, not changing the thicknesses of the active layers.

According to the wavelength-tunable light source of the present invention, since the surface-emitting elements may be disposed on the substrate on the circumferential of a circle in close proximity to each other, light emitted on the medium through a lens does not have positional dependency with respect to the medium. When the surface-emitting elements are disposed on the substrate in a line in close proximity to each other, the fabrication process is facilitated.

According to the method for fabricating the wavelength-tunable light source of the present invention, the surface-emitting elements having different two-dimensional periodic refractive index structures on the respective bottom cladding layers are formed on the substrate so that the different two-dimensional surface-emitting elements emitting light having respective wavelengths are formed simultaneously. The two-dimensional periodic refractive index structures can be easily fabricated by lithography and etching.

Embodiments of the invention will now be described, by way of example only, with reference to the accompanying drawings, in which:
Fig. 1 is a perspective view of a wavelength-tunable light source according to a first embodiment of the present invention;
Fig. 2 is a schematic view of an optical system according to the first embodiment;
Fig. 3 is a perspective view of a wavelength-tunable light source according to a second embodiment of the present invention;
Fig. 4 is a perspective view of a wavelength-tunable light source according to a third embodiment of the present invention;
Fig. 5 is a schematic view of a surface-emitting laser according to the present invention;
Figs. 6A to 6D are cross-sectional views showing steps of fabricating the surface-emitting laser; and
Figs. 7A to 7D are cross-sectional views showing steps of fabricating an emitting section of the present invention.

### DESCRIPTION OF THE PREFERRED EMBODIMENTS

Embodiments of the present invention will now be described by referring to the accompanying drawings. A wavelength-tunable light source of the present invention is used in a read-only holographic memory device. A hologram is created and written on a medium in the holographic memory device by interference between a signal beam and a reference beam or by copying a medium on which a hologram is previously recorded. To reproduce information recorded on the medium, the same reference beam that is used to create the hologram is incident on the medium, and the incident light is diffracted to reconstruct the original image. An optoelectronic transducer such as a CCD or CMOS device receives the diffracted light, thereby reproducing the information.

According to the present invention, holograms are created by wavelength multiplexing. That is, the wavelength of the reference beam is varied when writing the holograms on the medium such that a plurality of pieces of information is written at the same position. To reproduce the information, a light beam having the same wavelength as the reference beam that is used for writing the information is made incident on the medium at the same angle as the angle used when writing the information. The wavelength-tunable light source of the present invention emits light having a plurality of wavelengths in order to reconstruct the multiplexed holograms.

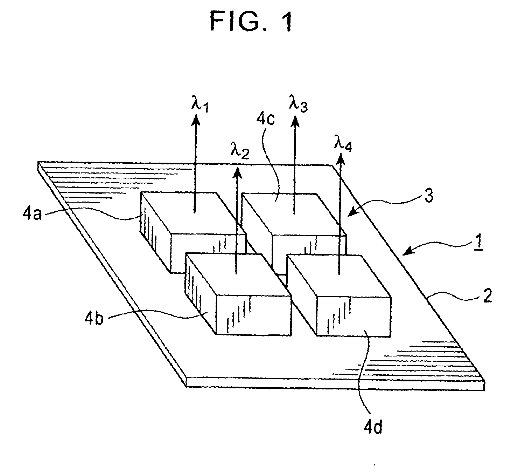

Fig. 1 is a perspective view of a wavelength-tunable light source 1 of a first embodiment. An emitting section 3 is composed of four surface-emitting elements, that is, surface-emitting lasers 4a, 4b, 4c, and 4d, which are set close to each other in an array. The emitting section 3 is disposed on a substrate 2 in the wavelength-tunable light source 1. The surface-emitting lasers 4a, 4b, 4c, and 4d emit light beams with different single wavelengths, respectively. The surface-emitting laser 4a oscillates light with a wavelength λ1, the surface-emitting laser 4b oscillates light with a wavelength λ2, the surface-emitting laser 4c oscillates light with a wavelength λ3, and the surface-emitting laser 4d oscillates light with a wavelength λ4. These wavelengths λ1, λ2, λ3, and λ4 are necessary to reconstruct a hologram 11a that is recorded on a medium 11 by wavelength multiplexing. The surface-emitting lasers 4a, 4b, 4c, and 4d are referred to as surface-emitting lasers 4 occasionally in the following description.

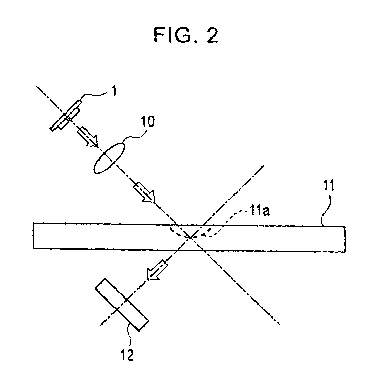

Fig. 2 is a schematic view of an optical system according to the first embodiment. The wavelength-tunable light source 1 is provided with a single collimating lens 10. This collimating lens 10 collimates diverging light from the wavelength-tunable light source 1. Alternatively, four collimating lenses set in an array corresponding to the respective surface-emitting lasers 4a, 4b, 4c, and 4d may be integrally formed with the wavelength-tunable light source 1. The collimated light is incident on an illuminated object or medium 11, and the incident light is diffracted by a hologram 11a, which is recorded at the incident position, to reconstruct the original image. The diffracted light then enters an optoelectronic transducer 12. When the hologram 11a is recorded with a reference beam having the wavelength λ1, the emitting section 3 emits light from the surface-emitting laser 4a in the wavelength-tunable light source 1.

To reconstruct the hologram 11a recorded on the medium 11, light is emitted from one of the surface-emitting lasers 4 that oscillates light having the wavelength corresponding to the target hologram 11a. After one hologram 11a is reconstructed, another surface-emitting laser 4 oscillates and light with a different wavelength is incident on the medium 11. Accordingly, holograms recorded at the same position by spatial multiplexing are reconstructed. By switching the surface-emitting lasers 4 in the emitting section 3, the holograms recorded on the medium 11 by wavelength multiplexing are reconstructed. Changing a current injected into the surface-emitting lasers 4 switches the wavelengths at very high speed as compared to a known wavelength-tunable light source. According to the first embodiment shown in Fig. 1, since the emitting section 3 is composed of the four surface-emitting lasers 4a, 4b, 4c, and 4d, multiplexed holograms stored in the medium 11 using four different wavelengths can be reconstructed.

In order for the wavelength-tunable light source 1 to emit reference beams in the holographic memory device, all of the light beams oscillated from the surface-emitting lasers 4 need to be incident on substantially the same position of the medium 11 at substantially the same angle. If the incident positions greatly differ among the light beams, the reference beam is not emitted on the target hologram and thus the information cannot be reconstructed from the hologram. If the light is incident on a medium at different angles, the bragg diffraction requirement is not satisfied in the hologram, thereby failing to reconstruct the hologram.

Therefore, the surface-emitting lasers 4 constituting the emitting section 3 have to be arranged as close as possible so that positional dependency of the surface-emitting lasers 4 on the substrate 2 is reduced. The surface-emitting lasers 4 are squares with a side of several tens of micrometers and are arranged in close proximity to each other, and the wavelength-tunable light source 1 and the medium 11 are disposed at a large distance. In this way, the influence of the positional dependency of the surface-emitting lasers 4 is negligible. That is, the wavelength-tunable light source 1 can effectively function as a single light source.

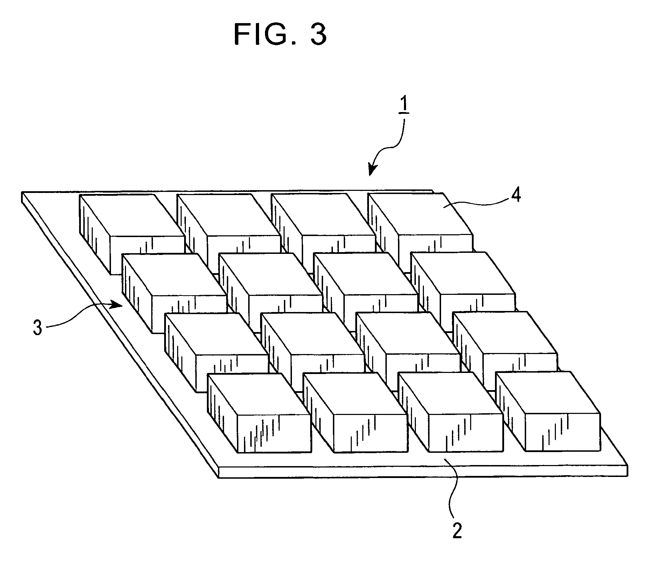

Fig. 3 is a perspective view of a wavelength-tunable light source according to a second embodiment. In the second embodiment, surface-emitting lasers 4 are arranged in four columns and four rows so that 16 surface-emitting lasers 4 in total are disposed in close proximity to each other in an emitting section 3. Similar to the wavelength-tunable light source 1 of the first embodiment, surface-emitting lasers 4 oscillate light beams having different wavelengths. When the number of surface-emitting lasers 4 increases, holograms recorded on the medium 11 with a higher degree of multiplexing can be reconstructed.

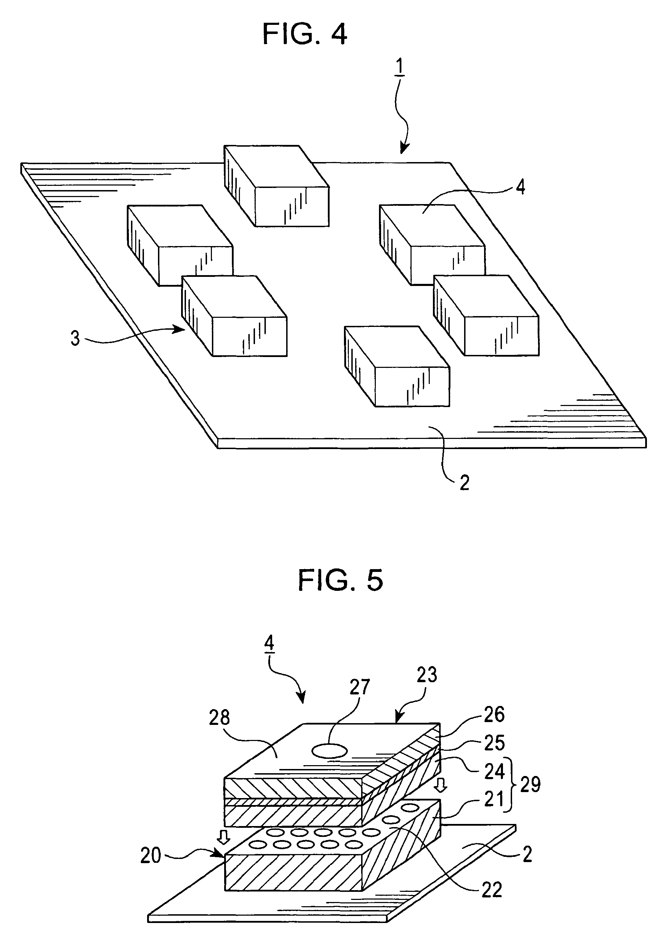

Fig. 4 is a perspective view of a wavelength-tunable light source of a third embodiment. In the wavelength-tunable light source of the third embodiment, surface-emitting lasers 4 are disposed at the same distance from one point on a substrate 2. That is, the surface-emitting lasers 4 are disposed on the circumference of a circle. By this arrangement, the light emitted from the surface-emitting lasers 4 does not have positional dependency with respect to the collimating lens 10. Accordingly, this arrangement further improves the positional dependency of the surface-emitting lasers 4, as compared to the above embodiments. The arrangement of the surface-emitting lasers 4 on the substrate 2 is, however, not limited to the ones described above. As long as the surface-emitting lasers 4 do not have positional dependency on the medium 11, any arrangement can be used. For example, the surface-emitting lasers 4 may be arranged in a line, in a triangle, or in any other polygonal shape. When the surface-emitting lasers 4 are arranged in a line, the fabrication of the light source can be simplified.

Now, the structure of the surface-emitting laser 4 will be described. Fig. 5 is a schematic view of the surface-emitting laser 4 described in the above-embodiments. The surface-emitting laser 4 includes a lower cladding layer 29, an upper cladding layer 26, and an active layer 25. The active layer 25 generates light and resides between the lower cladding layer 29 and the upper cladding layer 26. The lower cladding layer 29 is composed of a sub-lower-cladding layer 21 and a main-lower-cladding layer 24 and has a periodic structure 22, that is, a two-dimensional periodic refractive index structure. As shown in Fig. 5, in the periodic structure 22, holes with column shapes are arranged in a triangular lattice, at a distance corresponding to the period of the wavelength to be generated, thereby forming a periodic refractive index structure. That is, the periodic structure 22 assumes a photonic crystal. Due to the periodic distribution of refractive index, light is bragg-reflected to form a band gap of the light, thereby confining the light two-dimensionally. The periodic structure 22, i.e., the photonic crystal, functions as a light resonator so that light is diffracted in the direction perpendicular to the substrate 2 through bragg diffraction. Thus, the light is emitted from an emitting surface 28 in the vicinity of an upper electrode 27 formed on the emitting surface 28. Alternatively, the holes may be arranged in a tetragonal lattice.

The active layer 25 has a separate confinement heterostructure multiple quantum well (SCH-MQW) structure. The lower cladding layer 29 is composed of n-type indium phosphide (n-InP) semiconductor. The upper cladding layer 26 is composed of p-type indium phosphide (p-InP) semiconductor. The holes are disposed in the periodic structure 22 at intervals corresponding to the wavelength of light to be emitted from the surface-emitting laser 4. The intervals of the holes are varied in each surface-emitting laser 4 so that the wavelength of light differs among the surface-emitting lasers 4. For example, when the refractive index of the lower cladding layer 29 is 3.0 and when the surface-emitting laser 4 emits light with a wavelength of 650 nm, the intervals of the holes are each 0.217 µm. Accordingly, light with the desired wavelength is emitted. Although a single periodic structure 22 is provided in the lower cladding layer 29 in the above description, the construction of the periodic structure and the cladding layer is not limited thereto. For example, a periodic structure may be provided in one or more laminated cladding layers.

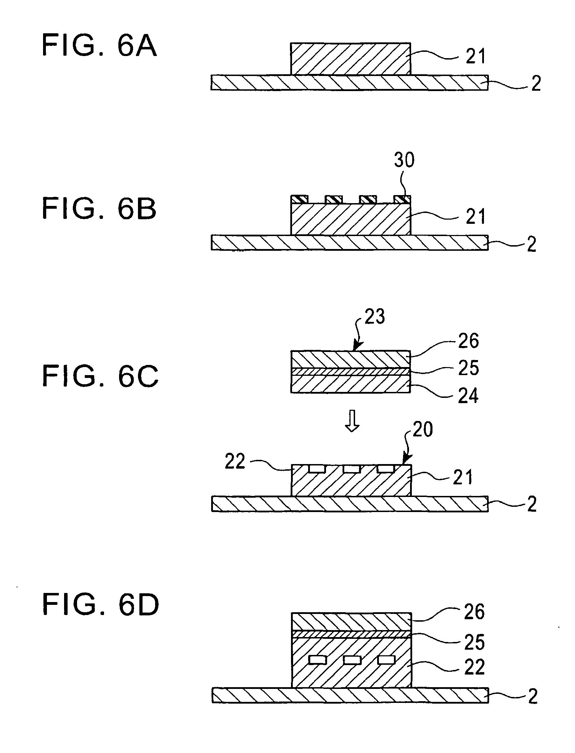

With reference to Figs. 6A to 6D, a method for fabricating the surface-emitting laser 4 will be described hereinbelow. Figs. 6A to 6D are steps of fabricating the surface-emitting laser 4. Referring to Fig. 6A, the sub-lower-cladding layer 21 is formed of n-InP on the substrate 2 by chemical vapor deposition (CVD). Thereafter, as shown in Fig. 6B, a photoresist 30 having a pattern of holes for the periodic structure 22 is formed on top of the sub-lower-cladding layer 21 by photolithography, and then dry etching is performed with etching gas such as chlorine-based gas. Consequently, portions that are not covered by the photoresist 30 are etched away and thus the periodic structure 22 corresponding to the pattern of the photoresist 30 is formed. Thereafter, the photoresist 30 is removed. Accordingly, a bottom structure 20 including the periodic structure 22 on the sub-lower-cladding layer 21 is formed, as shown in Fig. 6C.

An upper structure 23 is disposed on top of the bottom structure 20. The upper structure 23 is composed of the n-InP main-lower-cladding layer 24, the active layer 25 with the SCH-MQW structure, and the p-InP upper cladding layer 26. The bottom structure 20 and the upper structure 23 are integrated by wafer fusion. Specifically, application of a predetermined process to the bottom structure 20 and the upper structure 23 causes a transport phenomenon at the interface therebetween, thereby connecting the two structures.

By integrating the bottom structure 20 including the periodic structure 22 with the upper structure 23, the structure shown in Fig. 6D is completed. After that, the upper electrode 27 is formed on the upper cladding layer 26, and a bottom electrode (not shown) is formed on the substrate 2, thereby completing the surface-emitting laser 4. That is, the sub-lower-cladding layer 21 is formed on the substrate 2 and etching is performed through the photoresist 30 having a two-dimensional periodic pattern to form the bottom structure 20. The bottom face of the upper structure 23 composed of the active layer 25 for generating light, the main-lower-cladding layer 24, and the upper cladding layer 26 is connected to the upper face of the bottom structure 20 by wafer fusion. Thus, the surface-emitting laser 4 having the periodic structure 22 on the sub-lower-cladding layer 21 is completed.

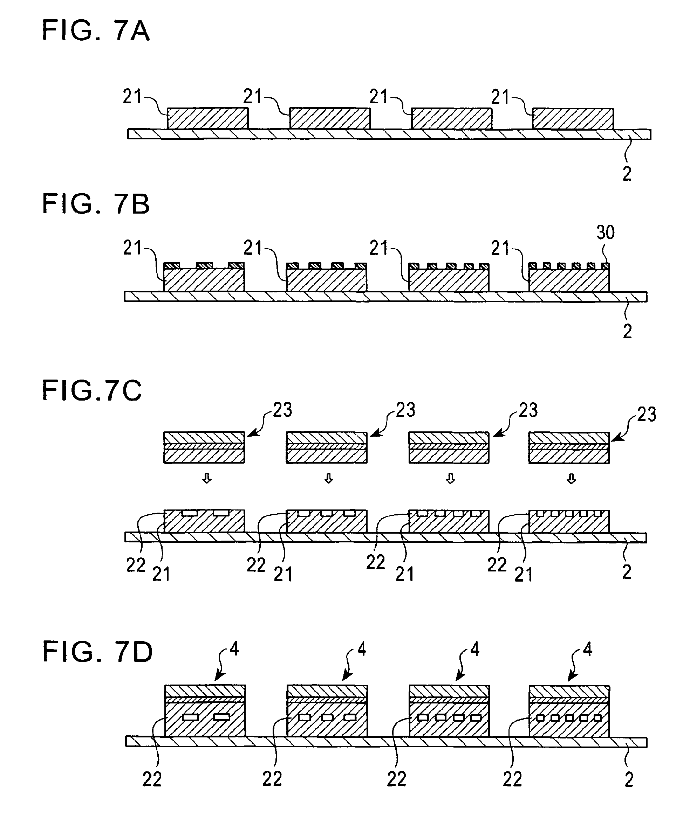

A method for fabricating the emitting section 3 including a plurality of the surface-emitting lasers 4 will now be described with reference to Figs. 7A to 7D. Figs. 7A to 7D illustrate steps of fabricating the emitting section 3. Referring to Fig. 7A, a plurality of the sub-lower-cladding layers 21 of n-InP are formed on the substrate 2 in close proximity to each other. The number of sub-lower-cladding layers 21 corresponds to the number of wavelengths of light to be emitted. Subsequently, the photoresists 30 for forming the different periodic structures 22 for respective surface-emitting lasers 4 are formed on the sub-lower-cladding layers 21, as shown in Fig. 7B. The photoresists 30 have individual patterns to form holes arranged in a triangular lattice or in a tetragonal lattice at different intervals corresponding to the wavelength of light to be emitted, allowing the surface-emitting lasers 4 to emit light having the desired wavelengths. Thereafter, dry etching is performed using, e.g., chlorine-based gas so that the portions that are not covered by the photoresists 30 are etched away. Accordingly, the periodic structures 22 corresponding to the patterns of the photoresists 30 are formed on the sub-lower-cladding layers 21. Thereafter, photoresists 30 are removed.

The upper structures 23 are disposed on the bottom structures 20 including the periodic structures 22 and are integrated with the bottom structures 20 by means of wafer fusion, as shown in Fig. 7C. Accordingly, the emitting section 3 including the surface-emitting lasers 4 with the periodic structures 22 is completed, as shown in Fig. 7D. In this emitting section 3, the surface-emitting lasers 4 emit light with respective wavelengths.

As described above, a plurality of the surface-emitting lasers 4 is formed on the substrate 2 simultaneously in one process so that the emitting section 3 is readily fabricated. To vary wavelengths in a known surface-emitting laser, the length of a resonator needs to be changed so that layers with different thicknesses have to be formed on a single substrate. This makes the fabrication process complicated. By contrast, according to the method for fabricating the emitting section of the invention, the cladding layers formed on the substrate 2 have the same thicknesses, and the periodic structures 22 formed through photolithography and etching determine the wavelengths of the light emitting from the surface-emitting lasers 4. Thus, the fabrication process of the emitting section 3 is simplified.

The present invention has been described above by referring to the embodiments. The present invention is not restricted to the above-described embodiments but may rather be modified within the scope of the invention. For example, the wavelength-tunable light source may be used in a holographic memory device capable of both writing and reading. In this application, light emitted from the light source is split into two beams, a signal beam and a reference beam.

## Claims

1. A wavelength-tunable light source (1) comprising:
a substrate (2); and
an emitting section (3) disposed on the substrate (2) and emitting light beams having a plurality of single wavelengths, the emitting section (3) including a plurality of surface-emitting elements (4a, 4b, 4c, 4d) disposed on the substrate (2) in close proximity to each other, the number of surface-emitting elements (4a, 4b, 4c, 4d) corresponding to the number of single wavelengths of the light beams emitted from the emitting section (3),
wherein each of the surface-emitting elements (4a, 4b, 4c, 4d) comprises two cladding layers (29, 26), and an active layer (25), the active layer (25) generating light and being disposed between the cladding layers (29, 26), one of the cladding layers (29, 26) including a region having a two-dimensional periodic refractive index structure (22),
wherein each of the surface-emitting elements (4a, 4b, 4c, 4d) in the emitting section (3) has a different periodic refractive index structure (22), and wherein the respective cladding layers of the surface-emitting elements have the same thickness as each other.

2. The wavelength-tunable light source (1) according to claim 1, wherein the light beams having the single wavelengths are incident on substantially the same position of an illuminated object (11), the light beams being emitted from the respective surface-emitting elements (4a, 4b, 4c, 4d) in the emitting section (3).

3. The wavelength-tunable light source (1) according to claim 2, wherein the illuminated object (11) is a medium in which holograms (11a) are recorded by wavelength multiplexing, and the surface-emitting elements (4a, 4b, 4c, 4d) emit respective reference beams having wavelengths necessary for reconstruction of the holograms (11a).

4. The wavelength-tunable light source (1) according to any claim 1 to 3, wherein the surface-emitting elements (4a, 4b, 4c, 4d) are disposed on the circumference of a circle in close proximity to each other on the substrate (2).

5. The wavelength-tunable light source (1) according to any claim 1 to 3, wherein the surface-emitting elements (4a, 4b, 4c, 4d) are disposed in a line in close proximity to each other on the substrate (2).

6. A method for forming a wavelength-tunable light source (1) including an emitting section (3) on a substrate (2), the emitting section (3) emitting light beams with a plurality of single wavelengths, the method comprising the steps of:
forming sub-lower-cladding layers (21) in close proximity to each other on the substrate (2), the number of sub-lower-cladding layers (21) corresponding to the number of wavelengths of the light beams to be emitted from the emiting section (3);
forming photoresists (30) having different two-dimensional periodic patterns on top of the sub-lower-cladding layers (21) by lithography;
etching the sub-lower-cladding layers (21) through the photoresists (30) to form different two-dimensional periodic structures on the respective sub-lower-cladding layers (21), thereby forming bottom structures (20);
forming upper structures (23) including main-lower cladding layers (24), upper cladding layers (26), and active layers (25), the active layers (25) generating light and being disposed between the main-lower cladding layers (24) and the upper cladding layers (26); and
connecting the upper faces of the bottom structures (20) with the bottom faces of the upper structures (23) by fusion, thereby forming surface-emitting elements (4a, 4b, 4c, 4d) in the emitting section (3).

## Patentansprüche

1. Lichtquelle mit abstimmbaren Wellenlängen (1) umfassend:
ein Substrat (2); und
einen Emittierabschnitt (3), der auf dem Substrat (2) angeordnet ist und Lichtstrahlen emittiert, die eine Mehrheit von Einzelwellenlängen aufweisen, wobei der Emittierabschnitt (3) eine Mehrheit von oberflächenemittierenden Elementen (4a, 4b, 4c, 4d) umfasst, die auf dem Substrat (2) in nächster Nähe zueinander angeordnet sind, wobei die Zahl von oberflächenemittierenden Elementen (4a, 4b, 4c, 4d) der Zahl von Einzelwellenlängen der vom Emittierabschnitt (3) emittierten Lichtstrahlen entspricht,
wobei jedes der oberflächenemittierenden Elemente (4a, 4b, 4c, 4d) zwei Mantelschichten (29, 26) und eine aktive Schicht (25) umfasst, die aktive Schicht (25) Licht generiert und zwischen den Mantelschichten (29, 26) angeordnet ist, wobei eine der Mantelschichten (29, 26) einen Bereich einschließt, der eine zweidimensionale periodische Brechungsindexstruktur (22) aufweist,
wobei jedes der oberflächenemittierenden Elemente (4a, 4b, 4c, 4d) im Emittierabschnitt (3) eine andere periodische Brechungsindexstruktur (22) aufweist und wobei die jeweiligen Mantelschichten der oberflächenemittierenden Elemente jeweils die gleiche Dicke haben.

2. Lichtquelle mit abstimmbaren Wellenlängen (1) nach Anspruch 1, wobei die Lichtstrahlen, die die Einzelwellenlängen aufweisen, im Wesentlichen auf die gleiche Position eines illuminierten Objekts (11) auftreffen, wobei die Lichtstrahlen von den jeweiligen oberflächenemittierenden Elementen (4a, 4b, 4c, 4d) im Emittierabschnitt (3) emittiert werden.

3. Lichtquelle mit abstimmbaren Wellenlängen (1) nach Anspruch 2, wobei das illuminierte Objekt (11) ein Medium ist, in dem Hologramme (11a) durch Wellenlängen-Multiplextechnik aufgezeichnet werden und die oberflächenemittierenden Elemente (4a, 4b, 4c, 4d) jeweilige Referenzstrahlen emittieren, die Wellenlängen aufweisen, die zur Rekonstruktion der Hologramme (11a) erforderlich sind.

4. Lichtquelle mit abstimmbaren Wellenlängen (1) nach einem der Ansprüche 1 bis 3, wobei die oberflächenemittierenden Elemente (4a, 4b, 4c, 4d) auf dem Umfang eines Kreises in nächster Nähe zueinander auf dem Substrat (2) angeordnet sind.

5. Lichtquelle mit abstimmbaren Wellenlängen (1) nach einem der Ansprüche 1 bis 3, wobei die oberflächenemittierenden Elemente (4a, 4b, 4c, 4d) in einer Linie in nächster Nähe zueinander auf dem Substrat (2) angeordnet sind.

6. Verfahren zum Bilden einer Lichtquelle mit abstimmbaren Wellenlängen (1), das einen emittierenden Abschnitt (3) auf einem Substrat (2) umfasst, wobei der emittierende Abschnitt (3) Lichtstrahlen mit einer Mehrheit von Einzelwellenlängen emittiert und das Verfahren folgende Schritte umfasst:
bilden untergeordneter unterer Mantelschichten (21) in nächster Nähe zueinander auf dem Substrat (2), wobei die Zahl der untergeordneten unteren Mantelschichten (21) der Zahl von Wellenlängen der vom Emittierabschnitt (3) zu emittierenden Lichtstrahlen entspricht;
bilden von Fotoresists (30) mit verschiedenen zweidimensionalen periodischen Mustern auf der Oberseite der untergeordneten unteren Mantelschichten (21) durch Lithografie;
ätzen der untergeordneten unteren Mantelschichten (21) durch die Fotoresists (30), um verschiedene zweidimensionale periodische Strukturen auf den jeweiligen untergeordneten unteren Mantelschichten (21) zu bilden, um **dadurch** untere Strukturen (20) zu bilden;
bilden oberer Strukturen (23), welche die hauptsächlichen unteren Mantelschichten (24), die oberen Mantelschichten (26) und aktive Schichten (25) umfassen, wobei die aktiven Schichten (25) Licht generieren und zwischen den hauptsächlichen unteren Mantelschichten (24) und den oberen Mantelschichten (26) angeordnet sind; und
verbinden der oberen Flächen der unteren Strukturen (20) mit den unteren Flächen der oberen Strukturen (23) durch Fusion, um **dadurch** oberflächenemittierende Elemente (4a, 4b, 4c, 4d) im Emittierabschnitt (3) zu bilden.

## Revendications

1. Source de lumière accordable en longueur d'onde (1) comportant :
un substrat (2) ; et
une section émettrice (3) disposée sur le substrat (2) et émettant des faisceaux de lumière ayant une pluralité de longueurs d'onde uniques, la section émettrice (3) comprenant une pluralité d'éléments à émission par la surface (4a, 4b, 4c, 4d) disposés sur le substrat (2) à proximité immédiate les uns par rapport aux autres, le nombre d'éléments à émission par la surface (4a, 4b, 4c, 4d) correspondant au nombre de longueurs d'onde uniques des faisceaux de lumière émis en provenance de la section émettrice (3),
dans laquelle chacun des éléments à émission par la surface (4a, 4b, 4c, 4d) comporte deux couches de métallisation (29, 26), et une couche active (25), la couche active (25) générant de la lumière et étant disposée entre les couches de métallisation (29, 26), l'une quelconque des couches de métallisation (29, 26) comprenant une région ayant une structure d'indice de réfraction périodique bidimensionnelle (22),
dans laquelle chacun des éléments à émission par la surface (4a, 4b, 4c, 4d) dans la section émettrice (3) a une structure d'indice de réfraction périodique différente (22), et dans laquelle les couches de métallisation respectives des éléments à émission par la surface ont la même épaisseur les unes par rapport aux autres.

2. Source de lumière accordable en longueur d'onde (1) selon la revendication 1, dans laquelle les faisceaux de lumière ayant les longueurs d'onde uniques sont incidents sur, dans une large mesure, la même position d'un objet lumineux (11), les faisceaux de lumière étant émis en provenance des éléments à émission par la surface respectifs (4a, 4b, 4c, 4d) dans la section émettrice (3).

3. Source de lumière accordable en longueur d'onde (1) selon la revendication 2, dans laquelle l'objet lumineux (11) est un support dans lequel des hologrammes (11a) sont enregistrés par multiplexage en longueurs d'onde, et les éléments à émission par la surface (4a, 4b, 4c, 4d) émettent des faisceaux de référence respectifs ayant les longueurs d'onde nécessaires pour la reconstruction des hologrammes (11a).

4. Source de lumière accordable en longueur d'onde (1) selon l'une quelconque des revendications 1 à 3, dans laquelle les éléments à émission par la surface (4a, 4b, 4c, 4d) sont disposés sur la circonférence d'un cercle à proximité immédiate les uns par rapport aux autres sur le substrat (2).

5. Source de lumière accordable en longueur d'onde (1) selon l'une quelconque des revendications 1 à 3, dans laquelle les éléments à émission par la surface (4a, 4b, 4c, 4d) sont disposés en une ligne à proximité immédiate les uns par rapport aux autres sur le substrat (2).

6. Procédé permettant de former une source de lumière accordable en longueur d'onde (1) comprenant une section émettrice (3) sur un substrat (2), le section émettrice (3) émettant des faisceaux de lumière avec une pluralité de longueurs d'onde uniques, le procédé comportant les étapes consistant à :
former des couches de métallisation inférieures sous-jacentes (21) à proximité immédiate les unes par rapport aux autres sur le substrat (2), le nombre de couches de métallisation inférieures sous-jacentes (21) correspondant au nombre de longueurs d'onde des faisceaux de lumière devant être émis en provenance de la section émettrice (3) ;
former des photorésines (30) ayant différentes configurations périodiques bidimensionnelles par-dessus les couches de métallisation inférieures sous-jacentes (21) par lithographie ;
attaquer chimiquement les couches de métallisation inférieures sous-jacentes (21) au travers des photorésines (30) pour former différentes structures périodiques bidimensionnelles sur les couches de métallisation inférieures sous-jacentes respectives (21), pour de ce fait former des structures inférieures (20) ;
former des structures supérieures (23) comprenant des couches de métallisation inférieures principales (24), des couches de métallisation supérieures (26), et des couches actives (25), les couches actives (25) générant de la lumière et étant disposées entre les couches de métallisation inférieures principales (24) et les couches de métallisation supérieures (26) ; et
connecter les faces supérieures des structures inférieures (20) aux faces inférieures des structures supérieures (23) par fusion, pour de ce fait former des éléments à émission par la surface (4a, 4b, 4c, 4d) dans la section émettrice (3).
